# FASCICULE DE BREVET EUROPEEN

(11) **EP 0 892 497 B1**
(45) Date de publication et mention de la délivrance du brevet: **03.11.2004**
(21) Numéro de dépôt: 98401706.1
(22) Date de dépôt: 06.07.1998
(51) Int. Cl.: H03K 5/00, H03B 19/00

(54) **Procédé de multiplication de la fréquence d'un signal d'horloge avec contrôle du rapport cyclique, et dispositif correspondant.**
Verfahren zur Frequenzvervielfachung eines Taktsignals mit Tastverhältnissteuerung und damit übereinkommende Vorrichtung
Method for frequency multiplication of a clock signal with duty cycle control and corresponding device

(30) Priorité: 16.07.1997 FR 9709022
(43) Date de publication de la demande: 20.01.1999
(73) Titulaire: STMicroelectronics S.A., 92120 Montrouge (FR)
(72) Inventeur: Cauchy, Xavier, 38240 Meylan (FR)
(74) Mandataire: Casalonga, Axel

(56) Documents cités:
- EP-A- 0 441 684
- US-A- 4 799 022
- US-A- 5 514 990
- "DOUBLE FREQUENCY CLOCK GENERATOR" IBM TECHNICAL DISCLOSURE BULLETIN, vol. 34, no. 3, 1 août 1991, pages 55-57, XP000210447

## Description

L'invention définie dans les revendications indépendantes 1 et 5 concerne le doublement de la fréquence d'un signal cyclique à fronts relativement raides, tel qu'un signal d'horloge incident, de façon à obtenir un signal de sortie de fréquence double et un rapport cyclique contrôlé, et plus généralement la multiplication d'un tel signal incident par une puissance entière de 2.

Une solution pour doubler la fréquence d'un signal d'horloge consiste à utiliser un oscillateur commandé en tension associé à une boucle à verrouillage de phase analogique.

Le document "Double frequency clock generator"; IBM Technical Disclosure Bulletin, Vol. 34, no. 3, 1 août 1991, p. 55-57 divulgue également un moyen de doubler la fréquence d'un signal.

L'invention vise à proposer une solution radicalement différente pour doubler la fréquence d'un signal d'horloge incident, en évitant le recours à des composants analogiques, ce qui permet d'intégrer aisément le multiplieur de fréquence selon l'invention dans un procédé de fabrication d'un circuit intégré ou puce.

Un but de l'invention est également de pouvoir contrôler le rapport cyclique du signal d'horloge de sortie, de fréquence double par rapport au signal d'horloge d'entrée, de façon à garantir notamment l'obtention de durées temporelles suffisantes pour les états hauts ou bas du signal de sortie, ce qui permet en particulier une exploitation correcte du signal de sortie par un autre composant d'un autre circuit intégré par exemple, même après déformation éventuelle des fronts de ce signal de sortie (entraînant, par conséquence, une réduction de la durée des états hauts ou bas stables) lors de son transfert par des plots de sortie et d'entrée des différentes puces.

L'invention propose donc un procédé de doublement de la fréquence d'un signal d'horloge incident, Selon une caractéristique générale de l'invention, on retarde le signal d'horloge incident d'un premier retard variable, on génère à partir de ce premier signal retardé, du signal d'horloge incident et d'une fonction logique du type OU EXCLUSIF, un signal d'horloge de sortie de fréquence double de celle du signal d'entrée. On compare le rapport cyclique du signal de sortie à une valeur de référence prédéterminée et on module la valeur du premier retard en fonction du résultat de la comparaison. On obtient ainsi un signal d'horloge de sortie de fréquence double avec un rapport cyclique contrôlé.

En pratique, on garantit ainsi des bornes minimales et maximales pour le rapport cyclique, la valeur idéale de référence de ce dernier étant typiquement 50%.

Selon un mode de mise en oeuvre du procédé selon l'invention, dans l'étape de comparaison du rapport cyclique, on retarde le signal de sortie d'un deuxième retard variable identique au premier retard, de façon à obtenir un deuxième signal retardé, et on échantillonne ce deuxième signal retardé en utilisant le signal incident. En pratique, bien que l'on puisse utiliser tous les fronts du signal incident pour échantillonner ce deuxième signal retardé, on ne procède à l'échantillonnage que sur les fronts montants du signal incident. On module alors la valeur des premier et deuxième retards en fonction de la valeur du signal échantillonné.

On réalise avantageusement chaque retard variable par une succession de retards élémentaires dont le nombre est variable et on module la valeur dudit retard en incrémentant ou en décrémeritant le nombre de retards élémentaires dans ladite succession.

De façon à éviter notamment une oscillation trop importante de la valeur du rapport cyclique du signal de sortie par rapport à la valeur idéale, on module avantageusement la valeur de chaque retard variable moins fréquemment que l'obtention du résultat de ladite comparaison du rapport cyclique du signal de sortie.

L'invention a également pour objet un dispositif de multiplication de la fréquence d'un signal d'horloge incident. Selon une caractéristique générale de l'invention, ce dispositif comprend au moins un bloc doubleur de fréquence. Ce bloc doubleur de fréquence comporte une borne d'entrée pour recevoir le signal incident, une première cellule de retard variable reliée à ladite borne d'entrée, une porte OU EXCLUSIF dont une entrée est reliée à la sortie de la première cellule de retard, dont l'autre entrée est reliée à ladite borne d'entrée du bloc doubleur de fréquence et dont la sortie est apte à délivrer un signal d'horloge de sortie de fréquence doublée par rapport à celle du signal incident. Le bloc doubleur de fréquence comporte également des moyens de comparaison pour comparer le rapport cyclique du signal de sortie à une valeur de référence prédéterminée (typiquement la valeur idéale de 50%) ainsi que des moyens de modulation pour moduler la valeur du premier retard en fonction du résultat de la comparaison.

Selon un mode de réalisation de l'invention, les moyens de comparaison comprennent une deuxième cellule de retard variable, identique à la première cellule de retard variable, et reliée à la sortie de la porte OU EXCLUSIF, cette deuxième cellule de retard variable délivrant un deuxième signal retardé. Les moyens de comparaison comportent également des moyens d'échantillonnage du deuxième signal retardé, reliés à la sortie de la deuxième cellule de retard, et commandés par le signal incident pour délivrer un signal échantillonné binaire. Les moyens de modulation comprennent un étage de commande possédant une entrée recevant le signal échantillonné binaire, et une sortie délivrant un signal de modulation aux première et deuxième cellules de retard de façon à augmenter ou à diminuer la valeur du retard en fonction de la valeur du signal échantillonné binaire.

L'étage de commande comprend avantageusement des moyens d'incrémentation/décrémentation possédant une entrée de commande reliée à l'entrée de l'étage de commande (et recevant par conséquent le signal échantillonné), une entrée reliée à la sortie de l'étage de commande et une sortie reliée à la sortie de l'étage de commande. Les moyens d'incrémentation/décrémentation sont aptes à incrémenter ou à décrémenter le signal de modulation en fonction de la valeur du signal échantillonné binaire. Chaque cellule de retard comporte une succession d'éléments de retard cascadés dont les sorties respectives de certains au moins d'entre eux sont reliées aux entrées d'un multiplexeur qui est commandé par le signal de modulation. La sortie du multiplexeur est reliée à la sortie de la cellule de retard.

Bien que les moyens d'échantillonnage puissent être constitués par exemple d'une seule bascule de type D, il est préférable que les moyens d'échantillonnage comprennent deux bascules connectées en série et commandées toutes deux par le signal incident. Ceci permet de minimiser les risques d'une éventuelle métastabilité de la première bascule lors de l'échantillonnage.

Selon un mode préféré de réalisation de l'invention, l'étage de commande des moyens de modulation comprend un sous-étage diviseur de fréquence recevant le signal incident et délivrant un signal de commande auxiliaire et ayant une fréquence égale à un sous-multiple prédéterminé de la fréquence du signal incident. Il est également prévu une bascule de sortie, dont l'entrée est reliée à la sortie des moyens d'incrémentation/décrémentation, dont la sortie est reliée à la sortie de l'étage de commande des moyens de modulation, et dont l'entrée de commande reçoit le signal de commande auxiliaire. Un tel dispositif permet de valider le signal de modulation pour sa prise en compte au niveau des cellules de retard à une fréquence inférieure à celle du signal incident ce qui permet de minimiser l'amplitude de l'oscillation du rapport cyclique par rapport à la valeur typiquement idéale de 50%.

Pour notamment obtenir des signaux d'horloge dont la fréquence est égale à 2ⁿ fois la fréquence de l'horloge du signal incident, n étant supérieur à 1, le dispositif selon l'invention comprend avantageusement plusieurs blocs doubleurs de fréquence connectés en série.

D'autres avantages et caractéristiques de l'invention apparaîtront à l'examen de la description détaillée d'un mode de réalisation et de mise en oeuvre, nullement limitatifs, et des dessins annexés sur lesquels :
- la figure 1 illustre de façon schématique un mode de réalisation d'un dispositif doubleur de fréquence selon l'invention et permettant une mise en oeuvre du procédé selon l'invention, et
- les figures 2a - 2d, 3a - 3d et 4a - 4d représentent des chronogrammes temporels permettant d'illustrer différents cas de fonctionnement du dispositif de la figure 1.

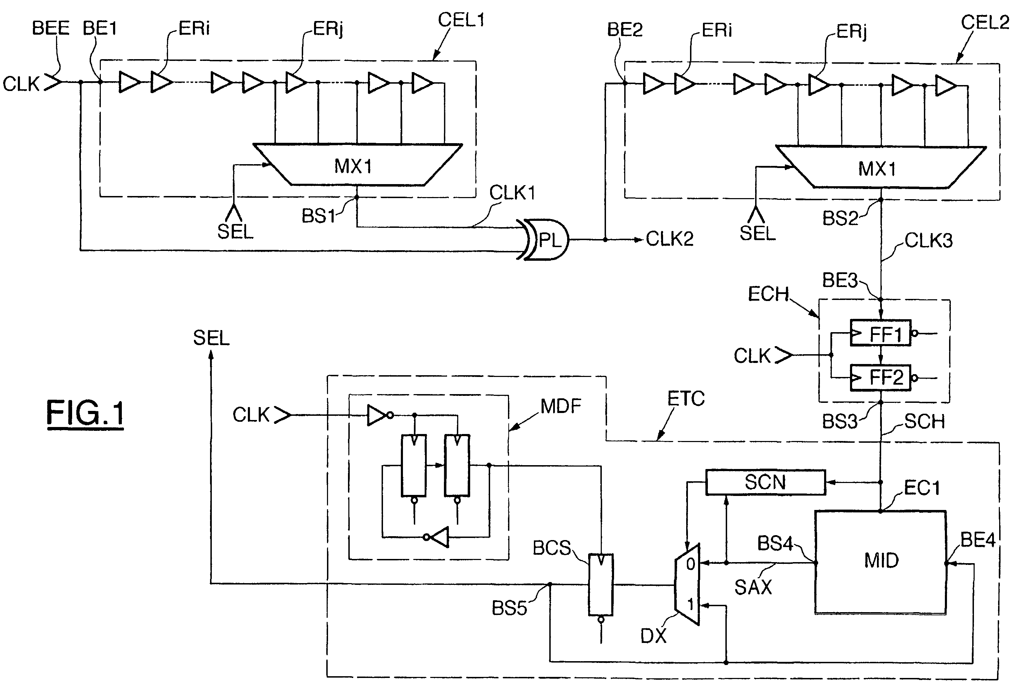

La figure 1 illustre un bloc doubleur de fréquence possédant une borne d'entrée BEE pour recevoir un signal d'horloge incident CLK. Une première cellule à retard variable CEL1 possède une entrée BE1 reliée à la borne d'entrée BEE et une borne de sortie BS1 reliée à une première entrée d'une porte logique OU EXCLUSIF PL.

Cette première cellule de retard CEL1 est constituée d'une succession d'éléments de retard formés ici d'éléments amplificateurs (buffers) non inverseurs, connectés en série. Une première série d'éléments de retard ERi contribue à obtenir une valeur minimale pour la valeur du retard temporel fournie par la cellule CEL1, tandis qu' une deuxième série d'éléments ERj, dont les sorties respectives sont en outre reliées aux entrées d'un multiplexeur MX1, contribuent, comme on le verra plus en détail ci-après, à moduler la valeur du retard global fournie par la cellule CEL1.

Ce multiplexeur MX1 possède une entrée de commande recevant un signal de modulation SEL dont on reviendra plus en détail sur la signification ci-après, ainsi qu'une sortie reliée à la sortie BS1 de la sortie CL1.

L'autre entrée de la porte logique PL est reliée à la borne d'entrée BEE du bloc doubleur de fréquence.

En conséquence, la porte logique PL reçoit d'une part le signal d'horloge incident CLK et d'autre part un premier signal d'horloge CLK1, délivré par la première cellule de retard CEL1, et retardé par rapport au signal incident CLK d'un premier retard Td dont la valeur dépend du nombre d'éléments de retard ERi, ERj effectivement connectés entre l'entrée BE1 et l'entrée sélectionnée du multiplexeur MX1.

En conséquence, la sortie de la porte logique PL, qui est en fait ici également la borne de sortie BSS du bloc doubleur de fréquence, délivre un signal d'horloge de sortie CLK2 dont la fréquence est automatiquement doublée par rapport à celle du signal d'horloge incident CLK.

Cependant, le rapport cyclique de ce signal de sortie CLK2, c'est-à-dire le rapport entre la durée de l'état haut (ou de l'état bas) de ce signal de sortie, et la durée totale du cycle, peut être sujet à des variations en raison des variations possibles de la valeur du retard Td induit par la première cellule de retard et provoquées notamment par des variations de température, de tension d'alimentation ou des variations lors du procédé de fabrication.

De façon à contrôler ce rapport cyclique, et notamment à garantir les variations du rapport cyclique entre des bornes minimales et maximales par rapport à une valeur idéale de 50%, le bloc doubleur selon l'invention comporte des moyens d'évaluation et de comparaison du rapport cyclique du signal de sortie CLK2 à la valeur idéale de 50%, ainsi que des moyens de modulation permettant de moduler notamment la valeur du premier retard Td induit par la première cellule de retard CEL1.

On va maintenant décrire plus en détail ces différents moyens.

Les moyens de comparaison comportent tout d'abord une deuxième cellule de retard variable CEL2 possédant une entrée BE2 reliée à la sortie de la porte logique PL ainsi qu'une sortie BS2. Cette deuxième cellule de retard variable est identique à la première cellule de retard variable CEL1 et son multiplexeur associé MX1 est également commandé par le signal de modulation SEL. Bien que ces deux cellules soient en théorie et en pratique identiques de façon à induire des premier et deuxième retards identiques Td, il est fortement recommandé, afin de minimiser encore les risques de différence entre ces deux retards, que les schémas de placement de leurs composants respectifs soient identiques, et que ces cellules soient disposées l'une à côté de l'autre sur le circuit intégré ou, mieux encore, imbriquées l'une dans l'autre.

La deuxième cellule CEL2 délivre donc un deuxième signal CLK3 retardé par rapport au signal CLK2 du retard Td.

Ce deuxième signal retardé CLK3 est délivré à l'entrée BE3 de moyens d'échantillonnage ECH composés ici de deux bascules de type D, connectées en série, et respectivement référencées FF1 et FF2. Ces deux bascules sont commandées par le signal d'horloge incident CLK, en pratique sur les fronts montants du signal CLK.

L'échantillonnage du deuxième signal retardé CLK3 permet de déterminer si le rapport cyclique du signal d'horloge de sortie CLK2 est trop faible ou trop important, et ce en fonction de la valeur du signal échantillonné SCH délivré à la sortie BS3 des moyens d'échantillonnage ECH. Ce signal SCH est en fait un signal binaire prenant soit la valeur "0", soit la valeur "1" et représentant ici la valeur du signal CLK3 lors des fronts montants du signal incident CLK.

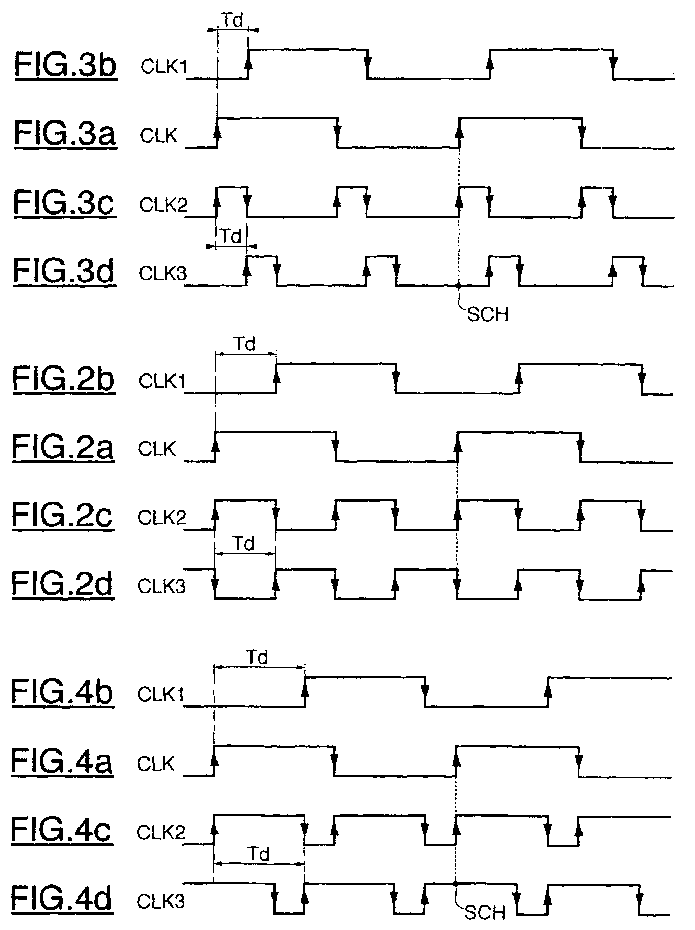

Ceci sera mieux compris en se référant maintenant plus particulièrement aux figures 2a - 2d, 3a - 3d et 4a - 4d.

Les figures 2a à 2d illustrent respectivement les quatre chronogrammes temporels des signaux CLK, CLK1, CLK2 et CLK3 pour une valeur du retard Td permettant d'obtenir idéalement un rapport cyclique de 50% pour le signal d'horloge de sortie CLK2.

Ceci étant, en raison notamment de variations de température de la puce ou de tension d'alimentation, la valeur du retard Td peut varier dans un sens ou dans l'autre.

Ainsi, on a représenté sur les figures 3a - 3d les chronogrammes temporels de ces quatre signaux d'horloge dans le cas où le retard Td est inférieur à la valeur idéale. On voit donc dans ce cas que le rapport cyclique du signal de sortie CLK2 est inférieur à 50%. Il convient donc d'augmenter la valeur du retard Td. La valeur trop faible de ce retard et donc, la valeur trop faible du rapport cyclique, se traduit, lors de l'échantillonnage du deuxième signal retardé CLK3 sur les fronts montants du signal incident CLK par une valeur nulle de ce signal CLK3, valeur nulle qui est stockée dans la deuxième bascule FF2 et qui constitue l'une des valeurs du signal échantillonné SCH. En d'autres termes, cette valeur nulle du signal SCH signifie que le front descendant du signal CLK3 s'est déjà produit (ce qui confirme la valeur trop faible du retard Td), donc trop tôt par rapport au cas idéal.

Les figures 4a - 4d illustrent le cas où la valeur du retard Td est trop élevée ce qui conduit à un rapport cyclique trop important pour le signal de sortie CLK2. Dans ce cas, lors de l'échantillonnage du signal CLK3 sur les fronts montants du signal incident CLK, la valeur "1" du signal CLK3 (qui représente l'autre valeur du signal échantillonné SCH) est présente dans la bascule FF2. Ceci signifie que, par rapport au cas idéal, le front descendant du signal CLK3 ne s'est pas encore produit ce qui traduit bien un retard Td trop important qu'il convient donc de réduire.

Le signal échantillonné SCH va alors être délivré aux moyens de modulation de façon à ce que ceux-ci élaborent le signal de modulation SEL commandant les multiplexeurs MX1 des deux cellules CEL 1 et CEL 2.

Plus précisément, d'une façon générale, si la valeur du signal SCH est représentative d'un retard Td trop faible, le signal de modulation SEL va agir sur le multiplexeur MX1 pour augmenter le nombre d'éléments de retard ERj de chaque cellule de retard, et augmenter ainsi la valeur du retard Td.

A contrario, si la valeur du signal SCH est représentative d'un retard Td trop important, le signal SEL va commander le multiplexeur MX1 de chaque cellule de façon à diminuer le nombre d'éléments de retard ERj connectés entre l'entrée et la sortie de chaque cellule de retard, diminuant ainsi la valeur globale Td du retard.

Plus précisément, selon le mode de réalisation illustré sur la figure 1, les moyens de modulation comportent un étage de commande ETC possédant une entrée de commande EC1 recevant le signal SCH et une sortie BS5 délivrant le signal de modulation SEL. Cet étage de commande ETC comporte en fait ici des moyens d'incrémentation/décrémentation MID possédant une entrée BE4 rebouclée sur la sortie BS5 de l'étage de commande. L'entrée EC1 est alors l'entrée de commande de ces moyens MID. Ceux-ci comportent par ailleurs une sortie BS4 reliée à l'une des entrées d'un duplexeur DX dont la sortie est reliée à l'entrée d'une bascule de sortie BCS de type D. La sortie de cette bascule BCS forme la sortie BS5 de l'étage de commande.

L'autre entrée du duplexeur DX est également rebouclée sur la sortie BS5.

Par ailleurs, des moyens de saturation SCN, dont on reviendra plus en détail ci-après sur la fonction, reçoivent d'une part le signal échantillonné SCH et, d'autre part le signal de sortie SAX délivré par les moyens d'incrémentation/décrémentation MID. La sortie de ces moyens de saturation commande le duplexeur DX.

Enfin, des moyens de division de fréquence MDF, de structure classique, et dont un exemple de réalisation à base de deux bascules de type D et de deux inverseurs est illustré sur la figure 1, sont connectés entre la borne d'entrée BEE du bloc doubleur de fréquence (de façon à recevoir le signal incident CLK), et l'entrée de commande de la bascule supplémentaire BCS.

En fonctionnement, les moyens d'incrémentation/décrémentation MID, réalisés de façon classique à partir de portes logiques, incrémentent ou décrémentent la valeur courante du signal de modulation SEL qui est présent, par rebouclage, sur l'entrée BE4 de ces moyens MID.

Les moyens de saturation SCN, réalisés également de façon classique au moyen de portes logiques, permettent, en combinaison avec le duplexeur DX, d'éviter un débordement. En effet, si la valeur du signal de modulation SEL en entrée BE4 des moyens MID, a déjà atteint sa valeur maximale et que le signal SCH demande une incrémentation, le signal de sortie SAX délivré par les moyens MID ne doit pas être valide car il y aurait alors débordement. Dans ce cas, les moyens de saturation SCN commandent le duplexeur DX sur son entrée "1" de façon à délivrer en entrée de la bascule BCS, l'ancienne valeur du signal de modulation SEL. Il en est bien sûr de même si la valeur courante du signal de modulation SEL a déjà atteint sa valeur minimale et que le signal SCH demande une décrémentation.

La commande des multiplexeurs MX1 des deux cellules de retard est synchronisée en sortie de l'étage de commande ETC de façon à parfaitement maîtriser l'instant où l'adjonction ou la suppression d'un élément de retard ERj va effectivement avoir lieu dans chaque cellule de retard.

Plus précisément, les moyens d'échantillonnage ECH introduisent un retard de deux coups d'horloge CLK dans la boucle d'asservissement en raison de la présence des deux bascules FF1 et FF2. Si l'on validait la mise à jour de la valeur du retard dans chaque cellule de retard à la fréquence du signal d'horloge incident CLK, on obtiendrait alors une oscillation maximale de part et d'autre de la position idéale (50%) équivalente à deux pas de retard élémentaire, c'est-à-dire à deux fois le temps de propagation à travers un élément de retard ERi. La présence des moyens de division de fréquence MDF et de la bascule de sortie BCS permet de valider la mise à jour du signal de modulation SEL à un quart de la fréquence du signal incident CLK, ce qui permet de limiter l'oscillation à un pas de retard.

Ceci étant, la présence de ces moyens de division de fréquence peut s'avérer non nécessaire dans certaines applications, notamment si l'on choisit des éléments de retard ERi ayant des temps de propagation extrêmement faibles.

En outre, la longueur du chemin de propagation du signal de modulation SEL jusqu'aux multiplexeurs MX1 est telle que les multiplexeurs MX1 sont positionnés avant que le front du signal incident n'ait eu le temps de se propager jusqu'au premier élément de retard ERj. C'est généralement le cas avec les techniques de réalisation et les composants classiquement utilisés dans les circuits intégrés.

Dans le cas où le rapport cyclique courant du signal de sortie CLK2 est précisément celui qui correspond à un changement de niveau du signal CLK3 lors d'un front montant du signal incident CLK, il y a alors un risque d'échantillonner une transition. Ce risque ne se produit que pour un petit nombre de combinaisons de conditions de fonctionnement prenant notamment en compte la température et la tension d'alimentation. Dès que qu'on s'écarte d'une telle condition, par exemple si la température de la puce augmente, on échantillonne à nouveau un niveau stable.

C'est pour mieux tenir compte de ce risque, que la valeur échantillonnée par la première bascule FF1 est avantageusement reprise par une deuxième bascule FF2 également commandée par le signal incident CLK. Ceci limite les effets d'une éventuelle métastabilité de la première bascule. Ainsi, la deuxième bascule pennet d'allouer un cycle complet du signal d'horloge CLK pour qu'une éventuelle valeur métastable ("flottante" ou "oscillante") en sortie de la première bascule FF1 ait le temps de se stabiliser à "1" ou à "0".

Enfin, en admettant que dans un cas exceptionnel il y ait également métastabilité en sortie de la deuxième bascule FF2, il en résulte que le signal d'échantillonnage SCH peut prendre approximativement la valeur "0" ou "1". Par conséquent, le signal de modulation peut aussi bien être incrémenté que décrémenté. Mais en fait, s'il y a eu métastabilité c'est que le rapport cyclique valait 50% et, le fait qu'on s'en écarte d'un cran par valeur inférfieure ou par valeur supérieure n'a alors que peu d'importance. Enfin, l'homme du métier aura noté que puisque de toute façon la valeur du signal de modulation va nécessairement changer, soit par incrémentation soit par décrémentation, le rapport cyclique suivant ne pourra pas provoquer de métastabilité.

Bien entendu, le nombre des éléments de retard ERi et ERj de chaque cellule de retard va déterminer les retards minimum et maximum qui peuvent être atteints. Ils sont donc choisis de manière à convenir au cas extrêmes attendus, c'est-à-dire de façon à pouvoir générer la largeur d'impulsion adéquate sur le signal de sortie pour avoir un rapport cyclique voisin de 50% dans toutes les conditions de fonctionnement. Par ailleurs, il est également possible de s'affranchir des moyens de saturation SCN en ajustant convenablement le nombre des éléments de retard dans chaque cellule, (au besoin en prévoyant un nombre volontairement trop important d'éléments de retard connectables et déconnectables) de façon à éviter les risques de saturation.

## Revendications

1. Procédé de doublement de la fréquence d'un signal d'horloge incident, dans lequel on retarde le signal d'horloge incident (CLK) d'un premier retard variable (Td), on génère à partir de ce premier signal retardé (CLK1), du signal d'horloge incident (CLK)et d'une fonction logique du type OU EXCLUSIF (PL), un signal d'horloge de sortie (CLK2) de fréquence double de celle du signal d'entrée, on compare le rapport cyclique du signal de sortie à une valeur de référence prédéterminée et on module la valeur du premier retard (Td) en fonction du résultat de la comparaison, de façon à obtenir un signal d'horloge de sortie de fréquence double et à rapport cyclique contrôlé, **caractérisé par le fait que** dans l'étape de comparaison du rapport cyclique, on retarde le signal de sortie (CLK2) d'un deuxième retard variable (Td) identique au premier retard de façon à obtenir un deuxième signal retardé et on échantillonne ce deuxième signal retardé en utilisant le signal incident (CLK), et **par le fait qu'**on module la valeur du premier et du deuxième retards en fonction de la valeur du signal échantillonné (SCH).

2. Procédé selon la revendication 1, **caractérisé par le fait que** ladite valeur de référence prédéterminée est égale à 50%.

3. Procédé selon la revendication 1 ou 2, **caractérisé par le fait qu'**on réalise chaque retard variable par une succession de retards élémentaires (ERi, ERj) dont le nombre est variable, et **par le fait qu'**on module la valeur dudit retard en incrémentant ou en décrémentant le nombre de retards élémentaires dans ladite succession.

4. Procédé selon l'une des revendications précédentes, **caractérisé par le fait qu'**on module la valeur de chaque retard (Td) moins fréquemment que l'obtention du résultat de ladite comparaison du rapport cyclique du signal de sortie (CLK2).

5. Dispositif de multiplication de la fréquence d'un signal d'horloge incident, comprenant au moins un bloc doubleur de fréquence comportant une borne d'entrée (BEE) pour le signal incident (CLK), une première cellule de retard variable (CEL1) reliée à ladite entrée, une porte OU EXCLUSIF (PL) dont une entrée est reliée à la sortie de la première cellule de retard (CEL1), dont l'autre entrée est reliée à ladite borne d'entrée (BEE), et dont la sortie est apte à délivrer un signal d'horloge de sortie (CLK2) de fréquence doublée par rapport à celle du signal incident, des moyens de comparaison (CEL2, ECH) pour comparer le rapport cyclique du signal de sortie à une valeur de référence prédéterminée et des moyens de modulation (ETC) pour moduler la valeur du premier retard en fonction du résultat de la comparaison, **caractérisé par le fait que** les moyens de comparaison comprennent une deuxième cellule de retard variable (CEL2), identique à la première cellule de retard variable (CEL1), reliée à la sortie de la porte OU EXCLUSIF, et délivrant un deuxième signal retardé (CLK3), des moyens d'échantillonnage (ECH) du deuxième signal retardé, reliés à la sortie de la deuxième cellule de retard, commandés par le signal incident et délivrant un signal échantillonné binaire(SCH), et **par le fait que** les moyens de modulation comprennent un étage de commande (ETC) possédant une entrée (EC1) recevant le signal échantillonné binaire, une sortie (BSS) délivrant un signal de modulation (SEL) à la première et à la deuxième cellules de retard de façon à augmenter ou à diminuer la valeur du retard (Td) en fonction de la valeur du signal échantillonné binaire.

6. Dispositif selon la revendication 5, **caractérisé par le fait que** la valeur de référence prédéterminée est égale à 50%.

7. Dispositif selon la revendication 5 ou 6, **caractérisé par le fait que** l'étage de commande (ETC) comprend des moyens d'incrémentation/décrémentation (MID) possédant une entrée de commande (EC1) reliée à l'entrée (EC1) de l'étage de commande, une entrée (BE4) reliée à la sortie de l'étage de commande et une sortie reliée à la sortie de l'étage de commande, les moyens d'incrémentation/décrémentation (MID) étant aptes à incrémenter ou à décrémenter le signal de modulation (CEL) en fonction de la valeur du signal échantillonné binaire, et **par le fait que** chaque cellule de retard comporte une succession d'élements de retard cascadés (ERi, ERj) dont les sorties respectives de certains au moins d'entre eux (ERj) sont reliées aux entreés d'un multiplexeur (MX1) commandé par le signal de modulation, la sortie du multplexeur étant reliée à la sortie de ladite cellule de retard.

8. Dispositif selon la révendication 5, 6 ou 7, **caractérisé par le fait que** les moyens d'échantillonnage comprennent deux bascules (FF1, FF2) connectées en série et commandées toutes deux par le signal incident.

9. Dispositif selon la revendication 7 ou 8, **caractérisé par le fait que** l'étage de commande des moyens de modulation comprend un sous-étage diviseur de fréquence (MDF) recevant le signal incident (CLK1) et délivrant un signal de commande auxiliaire ayant une fréquence égale à un sous-multiple prédéterminé de la fréquence du signal incident, et une bascule de sortie (BCS) dont l'entrée est reliée à la sortie des moyens d'incrémentation/décrémentation, dont la sortie est reliée à la sortie de l'étage de commande des moyens de modulation, et dont l'entrée de commande reçoit le signal de commande auxiliaire.

10. Dispositif selon l'une des revendications 5 à 9, **caractérisé par le fait qu'**il comprend plusieurs blocs doubleurs de fréquence connectés en série.

## Patentansprüche

1. Verfahren zum Verdoppeln der Frequenz eines eintreffenden Taktsignals, wobei das eintreffende Taktsignal (CLK) um eine erste variable Verzögerung (Td) verzögert wird, aus diesem ersten verzögerten Signal (CLK1), dem eintreffenden Taktsignal (CLK) und einer Logikfunktion des Typs EXKLUSIV ODER (PL) ein Ausgangstaktsignal (CLK2) erzeugt wird, das die doppelte Frequenz des Eingangssignals hat, das Tastverhältnis des Ausgangssignals mit einem vorgegebenen Referenzwert verglichen wird und der Wert der ersten Verzögerung (Td) als Funktion des Ergebnisses des Vergleichs moduliert wird, um ein Ausgangstaktsignal doppelter Frequenz und mit einem gesteuerten Tastverhältnis zu erhalten,
**dadurch gekennzeichnet, daß** im Schritt des Vergleichens des Tastverhältnisses das Ausgangssignal (CLK2) um eine zweite variable Verzögerung (Td), die zur ersten Verzögerung identisch ist, verzögert wird, um ein zweites verzögertes Signal zu erhalten, und dieses zweite verzögerte Signal unter Verwendung des eintreffenden Signals (CLK) abgetastet wird, und daß der Wert der ersten und zweiten Verzögerung als Funktion des Werts des abgetasteten Signals (SCH) moduliert wird.

2. Verfahren nach Anspruch 1, **dadurch gekennzeichnet, daß** der vorgegebene Referenzwert gleich 50% ist.

3. Verfahren nach Anspruch 1 oder 2, **dadurch gekennzeichnet, daß** jede variable Verzögerung durch eine Folge von elementaren Verzögerungen (ERi,ERj) erzeugt wird, deren Anzahl variabel ist, und daß durch Inkrementieren oder Dekrementieren der Anzahl der elementare Verzögerungen in dieser Folge der Wert der Verzögerung moduliert wird.

4. Verfahren nach einem der vorstehenden Ansprüche, **dadurch gekennzeichnet, daß** der Wert jeder Verzögerung (Td) weniger oft moduliert wird als das Ergebnis des Vergleichs des Tastverhältnisses des Ausgangssignals (CLK2) gewonnen wird.

5. Vorrichtung zum Vervielfachen der Frequenz eines eintreffenden Taktsignals, mit mindestens einem Frequenzverdopplerblock, der aufweist: einen Eingangsanschluß (BEE) für das eintreffende Signal (CLK), eine mit dem Eingang (BEE) verbundene erste variable Verzögerungszelle (CEL1), ein EXKLUSIV-ODER-Gatter (PL) mit einem Eingang, der mit dem Ausgang der ersten Verzögerungszelle (CEL1) verbunden ist, einem anderen Eingang, der mit dem Eingangsanschluß (BEE) verbunden ist, und einem Ausgang, der in der Lage ist, ein Ausgangstaktsignal (CLK2) auszugeben, das die doppelte Frequenz des eintreffenden Signals hat, Vergleichseinrichtungen (CEL2,ECH), um das Tastverhältnis des Ausgangssignals mit einem vorgegebenen Referenzwert zu vergleichen, und Modulationseinrichtungen (ETC), um den Wert der ersten Verzögerung als Funktion des Ergebnisses des Vergleichs zu modulieren,
**dadurch gekennzeichnet, daß** die Vergleichseinrichtungen aufweisen: eine mit dem Ausgang des EXKLUSIV-ODER-Gatters verbundene zweite variable Verzögerungszelle (CEL2), die zur ersten variablen Verzögerungszelle(CEL1) identisch ist und ein zweites verzögertes Signal (CLK3) ausgibt, Einrichtungen (ECH) zum Abtasten des zweiten verzögerten Signals (CLK3), die mit dem Ausgang der zweiten Verzögerungszelle verbunden sind, von dem eintreffenden Signal gesteuert werden und ein binäres abgetastetes Signal (SCH) ausgeben, und daß die Modulationseinrichtungen eine Steuerstufe (ETC) aufweisen, die einen Eingang (EC1), der das binäre abgetastete Signal empfängt, und einen Ausgang (BS5) besitzt, der ein Modulationssignal (SEL) zur ersten und zweiten Verzögerungszelle schickt, um den Wert der Verzögerung (Td) als Funktion des Werts des binären abgetasteten Signals zu erhöhen oder zu erniedrigen.

6. Vorrichtung nach Anspruch 5, **dadurch gekennzeichnet, daß** der vorgegebene Referenzwert gleich 50% ist.

7. Vorrichtung nach Anspruch 5 oder 6, **dadurch gekennzeichnet, daß** die Steuerstufe (ETC) Inkrementation/Dekrementation-Einrichtungen (MID) aufweist, die einen Steuereingang (EC1), der mit dem Eingang (EC1) der Steuerstufe verbunden ist, einen Eingang (BE4), der mit dem Ausgang der Steuerstufe verbunden ist, und einen Ausgang haben, der mit dem Ausgang der Steuerstufe verbunden ist, wobei die Inkrementation/ Dekrementation-Einrichtungen (MID) in der Lage sind, das Modulationssignal (SEL) als Funktion des Werts des binären abgetasteten Signals zu inkrementieren oder dekrementieren, und daß jede Verzögerungszelle eine Folge von Kaskaden-Verzögerungselementen (ERi,ERj) aufweist, wobei die Ausgänge mindestens einiger von ihnen (ERj) jeweils mit den Eingängen eines Multiplexers (MX1) verbunden sind, der von dem Modulationssignal gesteuert wird, wobei der Ausgang des Multiplexers mit dem Ausgang der Verzögerungszelle verbunden ist.

8. Vorrichtung nach Anspruch 5, 6 oder 7, **dadurch gekennzeichnet, daß** die Abtasteinrichtungen zwei Flipflops (FF1,FF2) aufweisen, die in Reihe geschaltet sind und alle beide von dem eintreffenden Signal gesteuert werden.

9. Vorrichtung nach Anspruch 7 oder 8, **dadurch gekennzeichnet, daß** die Steuerstufe der Modulationseinrichtungen eine Frequenzteiler-Unterstufe (MDF), die das eintreffende Signal (CLK) empfängt und ein Hilfssteuersignal ausgibt, das eine Frequenz gleich einem vorgegebenen Untervielfachen der Frequenz des eintreffenden Signals hat, und ein Ausgangsflipflop (BCS) aufweist, dessen Eingang mit dem Ausgang der Inkrementation/Dekrementation-Einrichtungen verbunden ist und dessen Ausgang mit dem Ausgang der Steuerstufe der Modulationseinrichtungen verbunden ist und dessen Steuereingang das Hilfssteuersignal empfängt.

10. Vorrichtung nach einem der Ansprüche 5 bis 9, **dadurch gekennzeichnet, daß** sie mehrere in Reihe geschaltete Frequenzverdopplerblöcke aufweist.

## Claims

1. Process for doubling the frequency of an incident clock signal, in which the incident clock signal (CLK) is delayed by a first variable delay (Td), an output clock signal (CLK2) with twice the frequency of the input signal is generated from this first delayed signal (CLK1), from the incident clock signal (CLK) and from a logic function of the EXCLUSIVE OR type (PL), the duty ratio of the output signal is compared with a predetermined reference value and the value of the first delay (Td) is modulated as a function of the result of the comparison, so as to obtain an output clock signal of twice the frequency and with a controlled duty ratio, **characterized in that** in the duty ratio comparison step, the output signal (CLK2) is delayed by a second variable delay (Td) identical to the first delay so as to obtain a second delayed signal and this second delayed signal is sampled using the incident signal (CLK), and **in that** the value of the first and of the second delays is modulated as a function of the value of the sampled signal (SCH).

2. Process according to Claim 1, **characterized in that** the said predetermined reference value is equal to 50%.

3. Process according to Claim 1 or 2, **characterized in that** each variable delay is produced from a succession of elementary delays (ERi, ERj) whose number is variable, and **in that** the value of the said delay is modulated by incrementing or decrementing the number of elementary delays in the said succession.

4. Process according to one of the preceding claims, **characterized in that** the value of each delay (Td) is modulated less frequently than the result of the said comparison of the duty ratio of the output signal (CLK2) is obtained.

5. Device for multiplying the frequency of an incident clock signal, comprising at least one frequency-doubling block which includes an input terminal (BEE) for the incident signal (CLK), a first variable delay cell (CEL1) linked to the said input, an EXCLUSIVE OR gate (PL), one input of which is linked to the output of the first delay cell (CEL1), the other input of which is linked to the said input terminal (BEE), and the output of which is able to deliver an output clock signal (CLK2) at twice the frequency of the incident signal, comparison means (CEL2, ECH) for comparing the duty ratio of the output signal with a predetermined reference value and modulation means (ETC) for modulating the value of the first delay as a function of the result of the comparison, **characterized in that** the comparison means comprise a second variable delay cell (CEL2) identical to the first variable delay cell (CEL1), linked to the output of the EXCLUSIVE OR gate and delivering a second delayed signal (CLK3), and means (ECH) for sampling the second delayed signal which are linked to the output of the second delay cell, are controlled by the incident signal and deliver a binary sampled signal (SCH), and **in that** the modulation means comprise a control stage (ETC) possessing an input (EC1) which receives the binary sampled signal, and an output (BS5) which delivers a modulation signal (SEL) to the first and second delay cells so as to increase or decrease the value of the delay (Td) as a function of the value of the binary sampled signal.

6. Device according to Claim 5, **characterized in that** the predetermined reference value is equal to 50%.

7. Device according to Claim 5 or 6, **characterized in that** the control stage (ETC) comprises incrementation/decrementation means (MID) possessing a control input (EC1) linked to the input (EC1) of the control stage, an input (BE4) linked to the output of the control stage and an output linked to the output of the control stage, the incrementation/decrementation means (MID) being able to increment or decrement the modulation signal (CEL) as a function of the value of the binary sampled signal, and **in that** each delay cell includes a succession of cascaded delay elements (ERi, ERj), the respective outputs of at least some of which (ERj) are linked to the inputs of a multiplexer (MX1) controlled by the modulation signal, the output of the multiplexer being linked to the output of the said delay cell.

8. Device according to Claim 5, 6 or 7, **characterized in that** the sampling means comprise two flip-flops (FF1, FF2) connected in series and both controlled by the incident signal.

9. Device according to Claim 7 or 8, **characterized in that** the control stage of the modulation means comprises a frequency-divider sub-stage (MDF) which receives the incident signal (CLK1) and delivers an auxiliary control signal having a frequency equal to a predetermined sub-multiple of the frequency of the incident signal, and an output flip-flop (BCS) whose input is linked to the output of the incrementation/decrementation means, whose output is linked to the output of the control stage of the modulation means, and whose control input receives the auxiliary control signal.

10. Device according to one of Claims 5 to 9, **characterized in that** it comprises several frequency-doubling blocks connected in series.
